(19) Europäisches Patentamt / European Patent Office / Office européen des brevets

(11) **EP 3 977 144 B1**

(12) **EUROPEAN PATENT SPECIFICATION**

(45) Date of publication and mention
of the grant of the patent:
**17.07.2024 Bulletin 2024/29**

(21) Application number: **19933833.6**

(22) Date of filing: **16.08.2019**

(51) International Patent Classification (IPC):
**G01R 27/18** *(2006.01)* **G01R 31/00** *(2006.01)*
**G01R 27/20** *(2006.01)*

(52) Cooperative Patent Classification (CPC):
**G01R 27/205; G01R 27/20**

(86) International application number:
**PCT/TR2019/050686**

(87) International publication number:
**WO 2020/256664 (24.12.2020 Gazette 2020/52)**

(54) **MEASURING THE GROUND RESISTANCE OF THE GROUNDING SYSTEM BY USING CAPACITIVE PROBE AND THE METHOD OF USAGE**

MESSUNG DES ERDWIDERSTANDES DES ERDUNGSSYSTEMS MITTELS KAPAZITIVER SONDE UND VERFAHREN ZUR VERWENDUNG

MESURE DE LA RÉSISTANCE DE TERRE D'UNE INSTALLATION DE MISE À LA TERRE À L'AIDE D'UNE SONDE CAPACITIVE ET PROCÉDÉ D'UTILISATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.06.2019 TR 201909146**

(43) Date of publication of application:
**06.04.2022 Bulletin 2022/14**

(73) Proprietor: **Hasan Kalyoncu Üniversitesi Gaziantep (TR)**

(72) Inventor: **KORASLI, Celal Sahinbey/Gaziantep (TR)**

(74) Representative: **Tasçi, Abdurrahman Kuantum Patent Inc. Florya Mevkii, Yesilova Mh. Sair Cikmazi Sk. No:1A Küçükçekmece-Istanbul (TR)**

(56) References cited:
**CN-A- 106 556 744 JP-A- 2008 232 953**

• **KAZUO MURAKAWA ET AL: "Proposal of earthing resistance measurement method without auxiliary electrodes", ELECTRICAL ENGINEERING IN JAPAN, JOHN WILEY & SONS, INC, US, vol. 154, no. 3, 28 December 2005 (2005-12-28), pages 16 - 26, XP071650314, ISSN: 0424-7760, DOI: 10.1002/EEJ.20196**
• **MURAKAWA MURAKAWA KAZUO KAZUO ET AL: "Earthing Resistance Tester developed using Resonant Circuit Technology with No Auxiliary Electrodes", MATHEMATICS AND COMPUTERS IN SCIENCE AND ENGINEERING SERIES, 31 January 2014 (2014-01-31), pages 155 - 164, XP093057447, Retrieved from the Internet <URL:https://www.wseas.org/multimedia/journals/communications/2014/a625704-310.pdf> [retrieved on 20230623]**

EP 3 977 144 B1

- JAMBAK M.I. ET AL: "Measurement of grounding system resistance based on ground high frequency behavior for different soil type", TENCON 200 PROCEEDINGS, vol. 2, 1 January 2000 (2000-01-01), Kuala Lumpur, pages 207 - 211, XP093057402, ISBN: 978-0-7803-6355-7, Retrieved from the Internet <URL:https://ieeexplore.ieee.org/stampPDF/get PDF.jsp?tp=&arnumber=892251&ref=aHR0cHM 6Ly9pZWVleHBsb3JlLmllZWUub3JnL2RvY3Vt W50Lzg5MjI1MT9hcm51bWJlcj04OTIyNTE=> [retrieved on 20230623], DOI: 10.1109/TENCON.2000.892251
- C. KORASLI ET AL.: "Ground Resistance Measurement with Fall-of-Potential Method Using Capacitive Test Probes", 2006, XP031070258

## Description

## Technological Area:

The present invention is related to a method for measuring the ground resistance of any types of grounding arrangement using a capacitive probe by applying the resonance method, which allows measurements on hard ground surfaces such as concrete blocks, stones or asphalt, where it is not possible to measure the ground resistance with the aid of ground-embedded probes.

## State of the Art:

Grounding of electrical power systems and equipment is an important issue in terms of ensuring operational safety in the event of electrical failures and lightning strikes. For this reason, a grounding system that maintains the standard ground resistance value during its service life is important for the safe operation of equipment in low-voltage and high-voltage power systems. Various methods are used to measure resistance of grounding systems. The commonly used method is known as the 3-probe or potential drop method. Measuring the resistance of any grounding system with this method requires the use of two auxiliary test electrodes (current and potential probes) connected to the measuring system. The test probes are buried directly in the ground at specific distances from the grounding electrode. The measurement is completed by injecting current into the grounding electrode and recording the voltage of the ground electrode with respect to the intermediate probe (voltage). The voltage / current ratio gives the resistance of the grounding electrode. It is not possible to measure resistance of any type of grounding system in urban areas by the fact that the free space around the grounding system is mostly covered with concrete, asphalt or stone blocks. In such cases, to measure resistance of grounding systems has led to the need to develop a measuring technique that does not require the use any test probes.

In the article by C. Korasli, "Ground Resistance Measurement with Fall-of-Potential Method Using Capacitive Test Probes," ESMO 2006 - 2006 IEEE 11th International Conference on Transmission & Distribution Construction, Operation and Live-Line Maintenance, Albuquerque, NM, USA, 2006, the use of capacitive probes developed by the applicant for ground resistance measurement of a grounding system is discussed. The application of capacitive probes instead of rod probes is well suited for ground resistance measurements of grounding systems in urban areas where the conventional rod probes are difficult to apply. Experimental data are presented and the results are compared with those of rod probes and possible sources of error are explained. It has been shown that capacitive probes can be used successfully in areas having hard ground surface structures instead of rod ground probes. The capacitive probe discussed above belongs to the inventor and will be used in the method of the invention.

In the known literature, the paper by Murakawa, Kazuo & Oohashi, Hideshi & Yamane, Hiroshi & Hattori, Mitsuo & Kuramoto, Shoichi & Machida, Masanobu & Kijima, Hitoshi, "Proposal of Earthing Resistance Measurement Method without Auxiliary Electrodes", January 2004, IEEJ Transactions on Fundamentals and Materials, discloses a method and equipment for measuring ground resistance of a simple electrode. The invention provides equipment that can accurately measure ground resistance without limiting the ground surface of the measuring zone and without the need of auxiliary electrodes (probe), and provides a method of measuring resistance using this equipment. In this method, the resonance measuring circuit consists of resistance of the grounding electrode and the capacitance and inductance of a long cable. If the resonance condition is met by changing the frequency of the current source injected into the measuring circuit of the invention, it is confirmed that the resistance of the measuring circuit corresponds to the resistance of the grounding electrode. However, this method and the recommended device could not achieve the desired efficiency because of its limited measuring range at lower resistive values of the grounding systems.

The paper by Kazuo Murakawa et al: "Proposal of earthing resistance measurement method without auxiliary electrodes", ELECTRICAL ENGINEERING IN JAPAN, JOHN WILEY & SONS, INC, US, vol. 154, no. 3, 28 December 2005 (2005-12-28), pages 16-26, discloses a method of measuring resistance of a grounding electrode without using auxiliary probes by using a metal plate acting as a capacitance. The metal plate is set upon the soil surface with Styrofoam or another insulating material in between, and is connected to the soil through static capacitance. An earth return circuit (RLC series resonant circuit) consisting of the electrode earthing resistance, the lead line impedance, and a static capacitance between the metal plate and soil is created. An impedance meter in the RLC circuit is used for determining the earthing resistance.

As a result, there is a need for a new technology that is easy to use, cost effective and capable of measuring resistance of grounding systems without using test probes and which can also overcome the above-mentioned disadvantage.

## Description of the Invention:

The present invention is a method and apparatus for measuring resistance of grounding and earthing systems using a capacitive probe according to independent claims 1 and 2. It is an easy-to-use, low-cost new technology that can measure resistance of grounding systems without using test probes, which can allow precision measurements on all kinds of ground surface structures. In order to accomplish all the objectives mentioned above and which will emerge from the detailed description below using the resonance method, the present invention allow the measurement of ground resistance without using auxiliary probes. Since it is not necessary to use ground-embedded test probes to measure resistance of grounding systems by the method of the invention; it makes it possible to measure the grounding resistance even in residential areas covered with concrete, asphalt or stone blocks where the population is dense where it is not possible to measure with conventional methods. The advantages of the method according to the invention will be apparent from the following figures and the detailed description written with reference to these figures, and therefore, the evaluation has to be made in consideration of these figures and the detailed description.

**Description of the Figures:**

The invention will now be described with reference to the accompanying figures, so that the features of the invention will be more clearly understood and appreciated, whereby the details are shown only for the purpose of illustrating preferred embodiments of the present invention and are provided the most useful and easily understood descriptions of both the method and the rules and conceptual features of the invention, whereby the invention is defined by the appended claims.

Figure 1    The circuit diagram of the invented system.

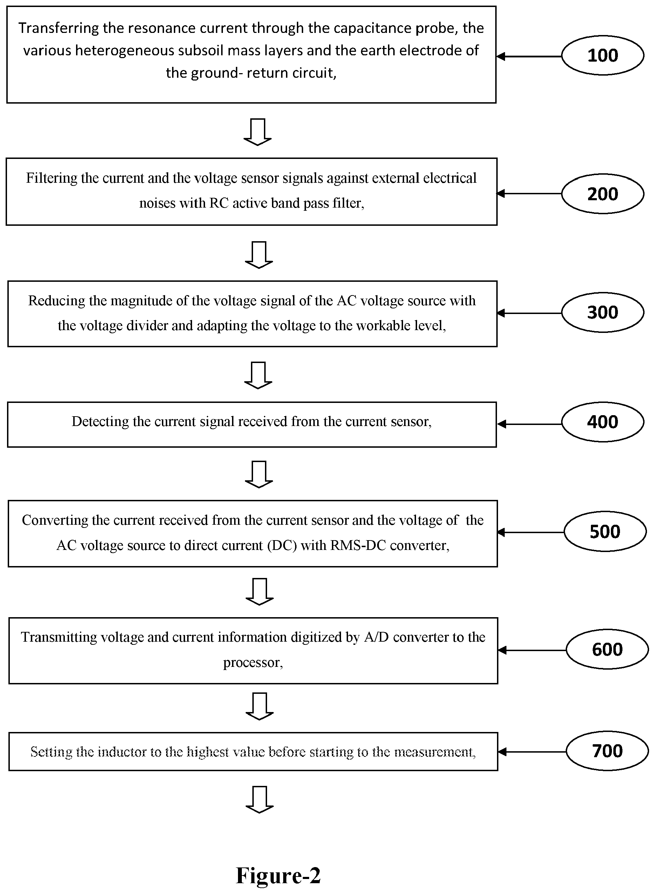

Figure 2    A schematic view of the operating mechanism of the invented system.

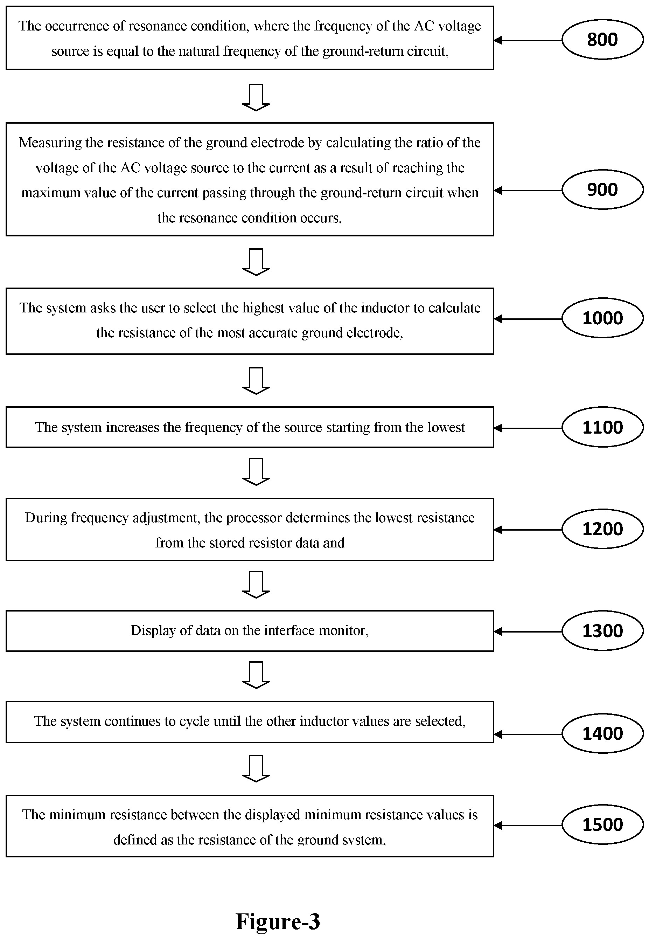

Figure 3    A schematic view of the operating mechanism of the invented system.

In the embodiment illustrated in Figure-1 and Figure-2, the blocks of figures which help to understand the present invention are numbered and are given below with their names.

**Disclosure of References:**

1. Capacitive Probe
2. Polyester Film
3. Cable
4. Aluminum Plate
5. Inductor
6. Current Sensor
7. AC Voltage Source
8. RC Active Band-Pass Filter
9. Voltage Divider
10. Current Signal Detecting Circuit
11. RMS-DC Converter
12. A/D Converter
13. Processor
14. Interface Screen

15. Ground-Return Circuit
16. Ground Electrode
100. Transferring the resonance current through the capacitance probe and the various heterogeneous subsoil mass layers to the ground electrode of the ground- return circuit
200. Filtering current signals received from the current sensor and voltage of the AC-source against external electrical noises with RC active band-pass filter
300. Reducing magnitude of the voltage across the AC voltage source with a voltage divider and adapting voltage to the workable level,
400. Detecting current signal received from the current sensor
500. Converting current and voltage signals received from the current sensor and across the AC voltage source to direct current (DC) with RMS-DC converter
600. Transmitting voltage and current information digitized by A/D converter to the processor
700. Setting the inductor to its highest value before starting to the measurement 800. The occurrence of resonance condition, where the frequency of the AC voltage source is equal to the natural frequency of the ground return circuit
900. Determining the resistance of the ground electrode by calculating the ratio of the voltage of the AC voltage source to the current received from the current probe when the maximum value of the current passing through the ground-return circuit is reached under the resonance condition
1000. The system asks the user to select the highest values of the inductor to calculate the resistance of the grounding electrode,
1100. The system increases the frequency of the source starting from the lowest value, 1200. During the frequency adjustment of the AC source, the processor determines the lowest resistance from the stored resistor data and
1300. Display of data on the interface screen
1400. The system continues to cycle until other inductor values are selected sequentially
1500. The minimum resistance value among the displayed values is defined as the resistance of the grounding electrode

**Disclosure of the Invention:**

The invention is of a resonance circuit comprising a ground return circuit (15) on which one inductor (5), one current sensor (6) and one AC voltage source (7) in series with the ground electrode (16), the voltage divider (9), the current signal sensor (10), the RC active-band pass filter (8) which performs filtering and corrective actions for the sensor current and AC voltage divider signals which are subjected to RMS-DC (11) and AC-DC (12) conversions, the processor (13) where the data is processed and stored, and the interface screen (14) where the data is displayed on the user side (Figure-1).

The invention is related to the transfer (100) of resonance current through the capacitive probe (1), the various heterogeneous subsoil mass layers and the ground electrode (16) to the ground-return circuit (15), filtering the voltage supplied from the AC voltage source (7) and the current from the current sensor (6) against external electrical noise (200) with the RC active band-pass filter (8), adapting the magnitude of the voltage signal of the AC voltage source (7) to the workable level (300) with the voltage divider (9), detecting and processing (400) the current signal received from the current sensor (10), converting (500) output voltage signal of the voltage divider (9) and output current signal of the current detecting circuit (10) to the direct current (DC) with the RMS-DC converter (11), digitizing (600) voltage and current signals by the A/D converter (12) and sending them to the processor (13), before starting the measurement adjusting (700) the inductor (5) to its highest to achieve resonance condition (800) at which the frequency of the AC voltage source (7) becomes equal to the natural frequency of the ground-return circuit (15) and the current passing through the ground- return circuit (15) becomes maximum value, the system measures the resistance (900) of the ground electrode (16) by calculating the ratio of the voltage to the current of the AC voltage source (7), and the system asks (1000) the user to select the next value of the inductor (5) to calculate the resistance of the ground electrode (16), increasing the frequency of the source starting from the lowest value (1100), during the frequency setting the processor (13) determines the lowest resistance among the stored resistor data (1200) and displays the data (1300) on the interface screen (14), the system continues the sequence (1400) until the other inductor values are selected sequentially, and displaying (1500) the minimum resistance among those displayed which is defined as the resistance of the grounding electrode (Figure-1, Figure-2, Figure-3).

**Detailed Description of the Invention:**

The basic elements of the invented system are; capacitive probe (1), polyester film (2), cable (3), aluminum plate (4), inductor (5), current sensor (6), AC voltage source (7), RC active band pass filter (8), voltage divider (9), current signal detecting circuit (10), RMS-DC converter (11), A/D converter (12), processor (13), interface screen (14), ground return circuit (15) and ground electrode (16) (Figure-1).

The present invention discloses a method for measuring ground resistance of any type of grounding system. The capacitive probe (1) used in the method of the present invention consists of 1.8 m x 3 m aluminum plate (4) which is insulated with 0.05 mm thick polyester film (2). The capacitive probe (1) is connected to ground-return circuit (15) by a coaxial cable (3) (Figure-1).

The effective dielectric constant of the composite dielectric layers under the invented capacitive probe plate is difficult to determine because of its statistical property of the dielectric layers due to their random volumetric distributions (and relative orientations). However, for n-layer composite dielectric it can be expressed as follows.

$$\varepsilon_{\mathrm{eff}} = F(\varepsilon_1, \varepsilon_2 \ldots, \varepsilon_{\mathrm{n}}, \theta_1, \theta_2 \ldots, \theta_n)$$

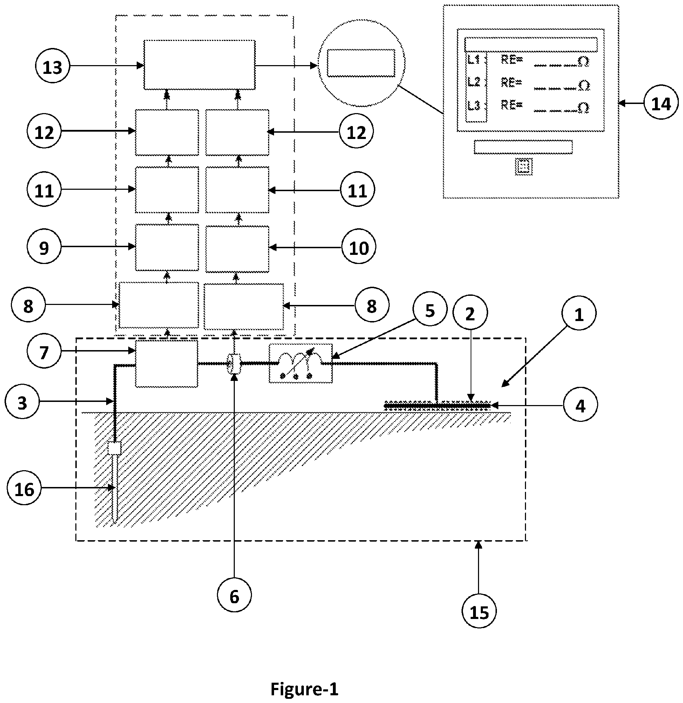

where $\varepsilon_1$, $\varepsilon_2$,..., $\varepsilon_n$ are respective effective dielectric permittivity constants of layers, and $\theta_1$, $\theta_2$..., $\theta_n$ fractions of volumes (percentages) of the corresponding layers (relative to the total volume). Thus, if the multi-layered subsoil mass under the aluminum plate (4) is represented as a dielectric layer having an effective dielectric constant $\varepsilon_{\mathrm{eff}}$, the capacitance of the probe (Figure 1) through which conduction taking place is expressed as $C = \varepsilon_{\mathrm{eff}} \varepsilon_0 (A/l)$, where $\varepsilon_0$ is the permittivity of vacuum, $A$ is the upper plate area of the capacitive ground-probe, and $l$ is the thickness of the soil mass between the upper capacitor plate and virtual soil layer having almost zero potential. If the volumetric ratio of the polyester film (2) of the capacitor probe and of the composite dielectric layer below the plate of the capacitive probe is $\theta$, the effective dielectric constant of two-layer composite is expressed as

$$\varepsilon_{eff} = \left[ \varepsilon_2^{1/3} + \theta \left( \varepsilon_1^{1/3} - \varepsilon_2^{1/3} \right) \right]^3$$

where $\varepsilon_1$ and $\varepsilon_2$ are the effective dielectric constants of polyester film of the capacitive probe and of the composite dielectric layers of the ground.

In order to determine the frequency range of the AC source (7) and the range of inductor values, substituting the relative dielectric constant of the upper polyester film (2) $\varepsilon_1 = 4$ and of the composite dielectric $\varepsilon_2 = 30$, and the volumetric ratio between the upper capacitive probe film and the lower soil layers, $\theta = 0.4$, the composite dielectric constant is found as $s_{\mathrm{eff}} = 28$. When the surface area of the applied capacitive probe (1) is taken as $A = 5.4 \ m^2$ and the soil thickness as $l = 0.1 \ m$, the capacitance of the capacitive probe (1) is approximately determined as $C \approx 15 \ nF$ (Figure-1). Using this value and the values of the series inductors to achieve the resonance condition in the ground-return circuit can be selected in the range 50mH-200 mH and the frequency of the AC voltage source (7) in range 5 kHz-100 kHz (Figure-1).

In the frequency limits of the AC voltage source the values of the inductors (7) connected in series to the ground-return circuit can be varied in the step of 25 mH from 25 mH to 75 mH (15).

In the ground -return circuit (15) of the present invention, the resonance current flows through the capacitive probe (1), the various heterogeneous subsoil mass layers and the ground electrode (16) (Figure-1). During the frequency setting two data signals are generated from the ground-return circuit (15), and both signals, which are voltage across the AC voltage source (7) and current obtained from the current sensor (6), are directed to the processor (13) after several filtering and corrective operations (Figure-1). Both signals are filtered against external electrical noise using RC active band-pass filter (8) (Figure-1). The magnitude of the voltage signal is adjusted to the workable level by decreasing it with the voltage divider (9), then it is converted to direct current (DC) by RMS-DC converter (11) (Figure-1). The RMS-DC converter (11) directs the voltage signal to the A/D converter (12) and the digitized voltage information is directed to the processor (13) (Figure-1). The current signal follows the same corrective actions as applied to the voltage signal. The output signal of the current sensor (6) is first filtered first using the RC active band-pass filter (8), the filtered signal being processed via the current signal detecting circuit (10), then converted to DC signal via the RMS-DC converter (11) and then to the A/D converter (12) and the digitized current data is directed to the processor (13) (Figure-1).

The basic steps forming the method according to the invention are as follows; the inductor (5) is set to its highest value before starting to measurement (Figure-1). The resonance condition is then sought in the frequency range 5kHz-100kHz of the AC voltage source (7) (Figure-1). The resonance condition means that the frequency of the AC voltage source (7) $w_{source}$ becomes equal to the natural frequency $w_{natural}$ of the ground-return circuit (15), that is, $w_{source}=w_{natural}$ or in terms of ground-return circuit elements L and C, the natural frequency of oscillation can be expressed as

$$w_{natural} = \frac{1}{\sqrt{LC}}$$

When the resonance condition is established, the current passing through the ground-return circuit (15) reaches to its maximum value and the ratio of the voltage of the AC voltage source (7) to the resonating current gives the resistance of the ground electrode (16) (Figure-1). Since the actual resistance of the ground electrode (16) is limited by the characteristics of the soil layers and surface structures of the ground, the most accurate ground resistance is obtained with three steps of the inductor (5) and in frequency range of the voltage source (Figure-1). The tests are repeated for each inductor (5) by using the 'inductor select' button on the display screen (14) to obtain the maximum current condition, and the corresponding resistance values are calculated and stored in the processor (13). The smallest resistance corresponding to each inductance is displayed (14) as the minimum resistance (Figure-1). Finally, the minimum resistance value among those displayed is defined as the resistance of the ground electrode.

At the beginning of measurement of the invented system the highest value of the inductor (5) is selected, then frequency of the source is increased in the frequency range 5kHz-100kHz. During frequency adjustment, the processor (13) determines the lowest resistance which corresponds to the resistance achieved at the resonance and displays it (14) (Figure-1). Tests for the other inductor settings (5) are repeated in the subsequent stages of the measurement, and the process is terminated (Figure-1). Among three stored resistance, the minimum resistance corresponds to the resistance of the ground electrode, the final result is displayed on the screen (14) (Figure-1).

**Claims**

1. A ground-return circuit for measuring a resistance of a grounding electrode (16) comprising a capacitive probe (1) with polyester film (2) and an aluminum plate (4) having;

   - an inductor (5) having three settings,
   - a current sensor (6),
   - an AC voltage source (7) driving a ground-return circuit (15),
   - the grounding electrode (16) subjected to a resonance current of the ground-return circuit (15),
   - an RC active band pass filter (8) configured to filter a current signal obtained from the current sensor (6) and a voltage obtained from the AC voltage source (7), a voltage divider (9), a current signal detecting circuit (10), an RMS-DC converter (11), and an A/D converter (12),
   - a processor (13) configured to process, store and display the data on an interface screen (14).

2. A method for measuring a resistance of a grounding electrode (16) using a capacitive probe (1), comprising:

   - transferring a resonance current to a ground-return circuit (15) via the capacitive probe (1), various heterogeneous subsoil mass layers and the grounding electrode (100),
   - filtering current and voltage signals received from a current sensor (6) and across an AC voltage source (7) respectively with an RC active band-pass filter (8) against external electrical noises (200),
   - reducing the magnitude of the voltage signal of the AC voltage source (7) with a voltage divider (9) and adapting the voltage to a workable level (300),
   - processing the current coming from the current sensor (6) by a current signal detecting circuit (400),
   - converting current and voltage signals received from the current sensor (6) and from the AC voltage source (7) to the direct current, DC, signals, with an RMS-DC converter (500),
   - transmitting the digitized current and voltage signals by an A/D converter (12) to a processor (600)
- adjusting an inductor (5) to the highest setting before starting the measurement (700),
- detecting occurrence of the resonance condition when the frequency of the AC voltage source (7) becomes equal to the natural frequency of the ground-return circuit (800),
- measuring the resistance of the ground electrode (16) by calculating the ratio of the voltage across the AC voltage source (7) to the resonance current obtained through the ground-return circuit, and storing measured resistance data in the processor (900),
- selecting another value of the inductor (5) to compute the resistance of the ground electrode (16), (1000),
- increasing the frequency of the source starting from the lowest value (1100),
- during frequency adjustment, determining by the processor (13) the lowest value among the stored resistance data (1200) and displaying it on the interface screen (1300),
- continuing cycling until three settings of inductor values are selected (1400),
- displaying the minimum resistance among three minimum resistance values and defining it as the ground resistance of the grounding electrode (1500).

## Patentansprüche

1. Erdungsrücklaufschaltung zum Messen des Widerstands einer Erdungselektrode (16), die eine kapazitive Sonde (1) mit Polyesterfilm (2) und eine Aluminiumplatte (4) aufweist;

   - einen Induktor (5) mit drei Einstellungen,
   - einen Stromsensor (6),
   - eine AC-Spannungsquelle (7), die eine Erdungsrücklaufschaltung (15) antreibt,
   - die Erdungselektrode (16), die einem Resonanzstrom der Erdungsrücklaufschaltung (15) ausgesetzt ist,
   - einen aktiven RC-Bandpassfilter (8), der dazu konfiguriert ist, ein vom Stromsensor (6) erhaltenes Stromsignal und eine von der AC-Spannungsquelle (7) erhaltene Spannung zu filtern, einen Spannungsteiler (9), eine Stromsignalerfassungsschaltung (10), einen RMS-DC-Wandler (11) und einen A/D-Wandler (12),
   - einen Prozessor (13), der dazu konfiguriert ist, die Daten zu verarbeiten, zu speichern und auf einem Schnittstellenbildschirm (14) anzuzeigen.

2. Verfahren zum Messen eines Widerstandes einer Erdungselektrode (16) unter Verwendung einer kapazitiven Sonde (1), umfassend:

   - Übertragung eines Resonanzstroms über die kapazitive Sonde (1), verschiedene heterogene Erdmassenschichten und die Erdungselektrode (100) an eine Erdungsrücklaufschaltung (15),
   - Filterung von Strom- und Spannungssignalen, die von einem Stromsensor (6) bzw. einer AC-Spannungsquelle (7) empfangen werden, mit einem aktiven RC-Bandpassfilter (8) gegen externe elektrische Geräusche (200),
   - Reduzierung der Größe des Spannungssignals der AC-Spannungsquelle (7) mit einem Spannungsteiler (9) und Anpassen der Spannung auf ein brauchbares Niveau (300),
   - Verarbeitung des vom Stromsensor (6) kommenden Stroms durch eine Stromsignalerfassungsschaltung (400),
   - Umwandlung der vom Stromsensor (6) und von der AC-Spannungsquelle (7) empfangenen Strom- und Spannungssignale in Gleichstrom-, DC-Signale mit einem RMS-DC-Wandler (500),
   - Übermittlung der digitalisierten Strom- und Spannungssignale durch einen A/D-Wandler (12) an einen Prozessor (600),
   - Einstellung eines Induktors (5) auf den höchsten Wert vor dem Beginn der Messung (700),
   - Erfassung des Auftretens der Resonanzbedingung, wenn die Frequenz der AC-Spannungsquelle (7) gleich der Eigenfrequenz der Erdungsrücklaufschaltung (800) wird,
   - Messung des Widerstands der Erdungselektrode (16) durch Berechnung des Verhältnisses zwischen der Spannung an der AC-Spannungsquelle (7) und dem durch die Erdungsrücklaufschaltung erhaltenen Resonanzstrom, und Speichern der gemessenen Widerstandsdaten im Prozessor (900),
   - Auswählen eines anderen Wertes des Induktors (5) zur Berechnung des Widerstandes der Masseelektrode (16), (1000),
   - Erhöhung der Frequenz der Quelle, beginnend mit dem niedrigsten Wert (1100),
   - während der Frequenzeinstellung Bestimmung des niedrigsten Wertes unter den gespeicherten Widerstandsdaten (1200) durch den Prozessor (13) und Anzeige dieses Wertes auf dem Schnittstellenbildschirm (1300),
   - Fortsetzen des Zyklus, bis drei Einstellungen der Induktivitätswerte ausgewählt sind (1400),
   - Anzeigen des Mindestwiderstands unter drei Mindestwiderstandswerten und Definieren dieses Werts als Erdungswiderstand der Erdungselektrode (1500).

## Revendications

1. Circuit de retour à la terre pour mesurer la résistance d'une électrode de mise à la terre (16) comprenant une sonde capacitive (1) avec un film polyester (2) et une plaque d'aluminium (4) ayant ;

   - un inducteur (5) à trois réglages,
   - un capteur de courant (6),
   - une source de tension CA (7) entraînant un circuit de retour à la terre (15),
   - l'électrode de mise à la terre (16) soumise à un courant de résonance du circuit de retour à la terre (15),
   - un filtre passe-bande actif RC (8) configuré pour filtrer un signal de courant obtenu à partir du capteur de courant (6) et une tension obtenue à partir de la source de tension CA (7), un diviseur de tension (9), un circuit de détection du signal de courant (10), un convertisseur RMS-DC (11) et un convertisseur A/N (12),
   - un processeur (13) configuré pour traiter, stocker et afficher les données sur un écran d'interface (14).

2. Méthode de mesure de la résistance d'une électrode de mise à la terre (16) à l'aide d'une sonde capacitive (1), comprenant :

   - transfert d'un courant de résonance vers un circuit de retour à la terre (15) via la sonde capacitive (1), diverses couches hétérogènes de la masse du sous-sol et l'électrode de mise à la terre (100),
   - filtrer les signaux de courant et de tension reçus respectivement d'un capteur de courant (6) et d'une source de tension CA (7) à l'aide d'un filtre passe-bande actif RC (8) contre les bruits électriques externes (200),
   - réduire l'amplitude du signal de tension de la source de tension CA (7) à l'aide d'un diviseur de tension (9) et adapter la tension à un niveau utilisable (300),
   - traitement du courant provenant du capteur de courant (6) par un circuit de détection du signal de courant (400),
   - convertir les signaux de courant et de tension reçus du capteur de courant (6) et de la source de tension CA (7) en signaux de courant continu (CC) à l'aide d'un convertisseur RMS-DC (500),
   - transmission des signaux de courant et de tension numérisés par un convertisseur A/N (12) à un processeur (600),
   - régler un inducteur (5) sur le réglage le plus élevé avant de commencer la mesure (700),
   - détecter l'apparition de la condition de résonance lorsque la fréquence de la source de tension CA (7) devient égale à la fréquence naturelle du circuit de retour à la terre (800),
   - mesurer la résistance de l'électrode de terre (16) en calculant le rapport entre la tension aux bornes de la source de tension CA (7) et le courant de résonance obtenu par le circuit de retour à la terre, et stocker les données relatives à la résistance mesurée dans le processeur (900),
   - sélection d'une autre valeur de l'inducteur (5) pour calculer la résistance de l'électrode de terre (16), (1000),
   - augmenter la fréquence de la source à partir de la valeur la plus basse (1100),
   - pendant le réglage de la fréquence, déterminer par le processeur (13) la valeur la plus basse parmi les données de résistance stockées (1200) et l'afficher sur l'écran de l'interface (1300),
   - continuer le cycle jusqu'à ce que trois réglages de valeurs d'inductance soient sélectionnés (1400),
   - afficher la résistance minimale parmi trois valeurs de résistance minimale et la définir comme la résistance de terre de l'électrode de mise à la terre (1500).

**Figure-1**

| | |
|---|---|
| Transferring the resonance current through the capacitance probe, the various heterogeneous subsoil mass layers and the earth electrode of the ground- return circuit, | 100 |

⇩

| | |
|---|---|
| Filtering the current and the voltage sensor signals against external electrical noises with RC active band pass filter, | 200 |

⇩

| | |
|---|---|
| Reducing the magnitude of the voltage signal of the AC voltage source with the voltage divider and adapting the voltage to the workable level, | 300 |

⇩

| | |
|---|---|
| Detecting the current signal received from the current sensor, | 400 |

⇩

| | |
|---|---|
| Converting the current received from the current sensor and the voltage of the AC voltage source to direct current (DC) with RMS-DC converter, | 500 |

⇩

| | |
|---|---|
| Transmitting voltage and current information digitized by A/D converter to the processor, | 600 |

⇩

| | |
|---|---|
| Setting the inductor to the highest value before starting to the measurement, | 700 |

⇩

**Figure-2**

| | |
|---|---|
| The occurrence of resonance condition, where the frequency of the AC voltage source is equal to the natural frequency of the ground-return circuit, | 800 |

⇩

| | |
|---|---|
| Measuring the resistance of the ground electrode by calculating the ratio of the voltage of the AC voltage source to the current as a result of reaching the maximum value of the current passing through the ground-return circuit when the resonance condition occurs, | 900 |

⇩

| | |
|---|---|
| The system asks the user to select the highest value of the inductor to calculate the resistance of the most accurate ground electrode, | 1000 |

⇩

| | |
|---|---|
| The system increases the frequency of the source starting from the lowest | 1100 |

⇩

| | |
|---|---|
| During frequency adjustment, the processor determines the lowest resistance from the stored resistor data and | 1200 |

⇩

| | |
|---|---|
| Display of data on the interface monitor, | 1300 |

⇩

| | |
|---|---|
| The system continues to cycle until the other inductor values are selected, | 1400 |

⇩

| | |
|---|---|
| The minimum resistance between the displayed minimum resistance values is defined as the resistance of the ground system, | 1500 |

**Figure-3**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **C. KORASLI.** Ground Resistance Measurement with Fall-of-Potential Method Using Capacitive Test Probes. *ESMO 2006 - 2006 IEEE 11th International Conference on Transmission & Distribution Construction, Operation and Live-Line Maintenance,* 2006

- **MURAKAWA, KAZUO ; OOHASHI, HIDESHI ; YAMANE, HIROSHI ; HATTORI, MITSUO ; KURAMOTO, SHOICHI ; MACHIDA, MASANOBU ; KIJIMA, HITOSHI.** Proposal of Earthing Resistance Measurement Method without Auxiliary Electrodes. *IEEJ Transactions on Fundamentals and Materials,* January 2004
- Proposal of earthing resistance measurement method without auxiliary electrodes. **KAZUO MURAKAWA et al.** ELECTRICAL ENGINEERING IN JAPAN. JOHN WILEY & SONS, INC, 28 December 2005, vol. 154, 16-26